# EUROPEAN PATENT SPECIFICATION

(11) **EP 1 071 133 B1**
(45) Date of publication and mention of the grant of the patent: **21.04.2010**
(21) Application number: 99830468.7
(22) Date of filing: 21.07.1999
(51) Int. Cl.: H01L 27/105, H01L 21/8249

(54) **Process for CMOS devices of non volatile memories and vertical bipolar transistors with high gain.**
Verfahren zum Herstellen von CMOS Transistoren nichtflüchtiger Speicher und von vertikalen Bipolartransistoren mit hohem Verstärkungsfaktor
Procédé de fabrication de dispositifs CMOS de mémoires non volatiles avec transistors bipolaires verticaux ayant un gain élevé

(43) Date of publication of application: 24.01.2001
(73) Proprietor: STMicroelectronics Srl, 20041 Agrate Brianza (MB) (IT)
(72) Inventor: Vendrame, Loris, 31030 Carbonera (TV) (IT); Ghezzi, Paolo, 26027 Rivolta d'Adda (CR) (IT)
(74) Representative: Viering, Jentschura & Partner

(56) References cited:
- US-A- 5 005 066
- US-A- 5 011 784
- US-A- 5 605 850
- US-A- 5 837 554
- ANONYMOUS: "Emitter Structure with Different Impurity Concentrations. June 1976." IBM TECHNICAL DISCLOSURE BULLETIN, vol. 19, no. 1, pages 162-163, XP002125648 New York, US

## Description

The present invention refers to a building process for a bipolar transistor obtained by means of a process for CMOS devices for non volatile memories.

In some circuital applications it is desirable to insert the bipolar transistors in the integrated digital circuits of CMOS type.

Besides, for an easier construction of such integrated circuits it is desirable to have a building process of manufacture in which both the bipolar transistors and the CMOS transistors are formed using the same masks and with a minimum number of phases of process.

It is known to get bipolar transistors integrated in CMOS circuits at low voltage, using substantially the same phases of the process. These devices present however current gains very low in the order of few tens.

In view of the described prior art the aim of the present invention is that of optimising the current gain of a bipolar transistor, using a CMOS process for non volatile memories, without adding new phases of process.

Further processes are disclosed in US 5005066 and US 5011784

According to the present invention, such a purpose is reached through a process of construction of a bipolar transistor obtained by means of a process for CMOS devices in non volatile memories, having a gate region, a source region and a drain region comprising the phases of: forming a semiconductor buried layer having a second type of conductivity on a substrate having a first type of conductivity, simultaneously to the formation of an similar layer of buried semiconductor for said CMOS devices of n type, forming an isolation semiconductor layer having a second type of conductivity in direct contact with said semiconductor buried layer and adapted to contain a portion of said substrate forming the base region simultaneously to the formation of the n-well area of one of said CMOS devices ofp type, forming an emitter region and a collector contact region respectively in said base region and in said isolation semiconductor layer having a second type of conductivity simultaneously to the formation a similar semiconductor layer for said source and drain regions of a said CMOS device of n type, forming a base contact region of said transistor in said base region having a first type of conductivity simultaneously to the formation of a similar layer of semiconductor for said source and drain regions of said CMOS devices ofp type.

Thanks to the present invention it is possible to realise a high gain bipolar transistor using substantially the same process phases of high voltage CMOS devices particularly those used in the circuits for non volatile memories

The characteristics and the advantages of the present invention will result evident from the following detailed description of one of its forms of practical realisation, illustrated as example not limitative in the joined figures, in which:
the figure 1 shows a cross section of a NPN transistor according to a first embodiment of the present invention;
the figure 2 shows in plant the NPN transistor of figure 1;
the figure 3 shows a cross section of a NPN transistor according to a second embodiment of the present invention;
the figure 4 shows in plant the NPN transistor of figure 3;
the figure 5 shows in a graph the trend of the current gain of a transistor of the known art and of two transistors according to the two transistor embodiments according to the present invention.

In the devices that include programmable and erasable memory matrix cells, it is always necessary to internally manage the necessary voltages necessary to the programming and to the erasing of the memory cells. In general, these voltages are greater than the necessary working voltages of the logical circuits of the devices. In the devices with cells of non volatile memory are present simultaneously circuits at low voltage and circuits that must manage negative voltages and/or high voltages necessary for the electric erasing and programming of the memory cells itself. For example, in the devices of last generation the working voltage of the logical circuits is of 3.3 V while for the programming of memory cells are necessary voltages of the order of 10V.

In the devices with non volatile memory matrixes it is always necessary to realise circuits comprising elementary elements able to bear the operative voltages for the programming and the erasing of the elementary memory cell. To guarantee the working of the CMOS circuits at high voltage, without any penalisation of the logical circuits at low voltage, regions of substrate are normally realised (both of N type and of P type) with doping concentrations inferior to those of the substrate in which low voltage circuits are normally realised. For example, the doping concentrations for the semiconductors called at low voltage are included between 10¹⁸ and 10²¹ impurity/cm³, while the concentrations of doping for the semiconductors called at high voltage are included between 10¹⁵ and 10¹⁷ impurity/cm³.

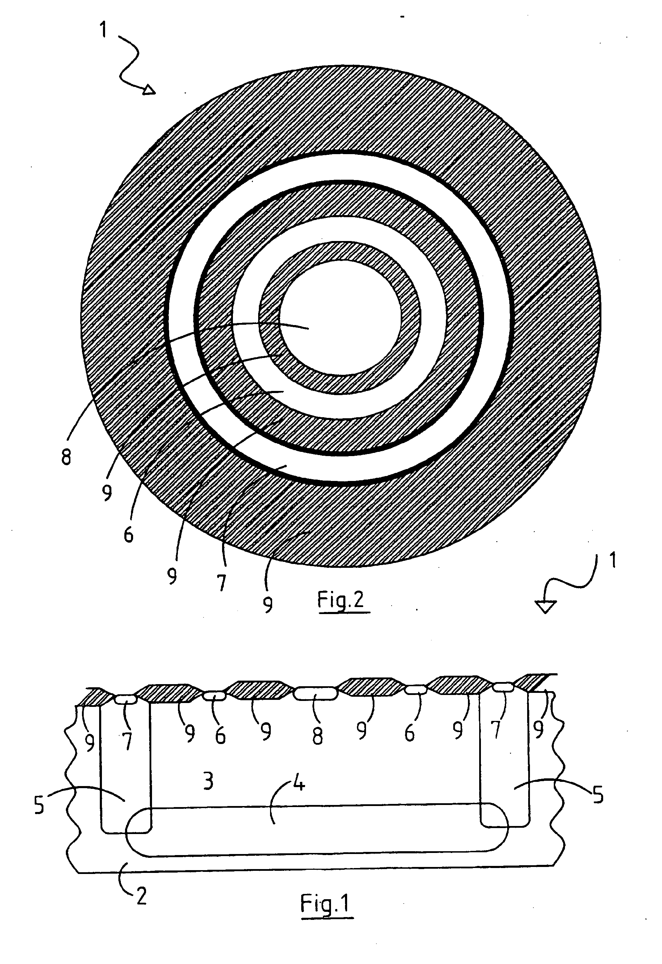

A first embodiment of the present invention is shown in figure 1.

The transistor 1 is formed on a semiconductor substrate 2 doped with a prefixed dose of a first type doping, for example of p type.

Within the substrate 2 is formed a buried layer 4 doped with a prefixed dose of a second type doping, of type n. The layer 4 is obtained by an implantation phase, preferably of phosphor, at high energy.

With the aim of insulating the region 3 from the substrate 2 some insulating regions 5 doped with a prefixed dose of a second type doping are created, of n type. Such regions, starting from the surface of the transistor 1, extents in depth until to contact the buried layer 4. The isolating regions 5 constitute with the buried layer 4 the collector region. The region 3 consist in the base region.

Inside the region 3 the regions that represent the region of emitter (which coincides with the contact region of emitter) 8 are formed and the contact region of base 6, strongly doped respectively of type n and p.

Inside the isolation regions 5 the region that represents the region of contact of collector 7 is formed, strongly doped of n type.

The contact regions of base 6, of collector contact 7 and the emitter region 8 are formed on the surface of the layer 3 and are isolated in between by areas of field oxide 9.

A preferred embodiment of the transistor 1 is the circular one represented in figure 2 where it is shown the sight in plan of the transistor 1. The region 5 forms in this way a circular enclosure which limits laterally the base region 3; the buried layer 4 limits the base region 3 from the underneath substrate 2. The collector contact region 7, of base contact 6, and the areas of field oxide 9 form circular rings on the surface of transistor 1.

Other forms are also possible, for example octagonal and quadrangular.

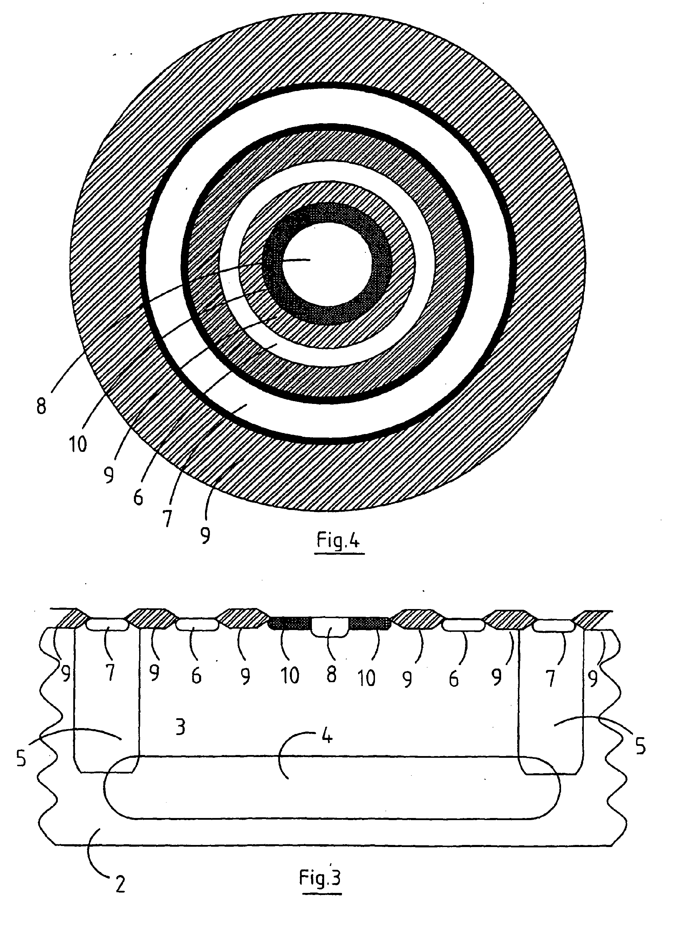

The cross section of figure 3 and the relevant plant sight of figure 4, that represent a second embodiment of the present invention, differ from the previous first embodiment, shown in figures 1 and 2, by further including a semiconductor region 10, which corresponds to the active region of emitter, preferably of circular form, which surrounds the contact region of emitter 8. The region 10 is lightly doped with a prefixed dose of a second type doping, of n type, besides it is of the type used in MOS transistors called "drain extension" and it is called "drex".

The peculiarity of the transistor of figure 1 and of figure 3 is that of utilising a region 3, called "ip-well", substantially equal to that utilised simultaneously for the formation on the same wafer of a similar layer for the CMOS transistors at high voltage. Such a region 3 has a doping dose included between 10¹⁶ and 10¹⁷ atoms/cm³.

The doping concentration of the isolating region 5 and of the buried layer 4 is of the order of 10¹⁷ atoms/cm³, (included between 10¹⁷ and 10¹⁸ atoms/cm³).

The doping dose of the base contact region 6, of the emitter region 8, and of the collector contact region 7, have a doping concentration included between 10²⁰ and 10²¹ atoms/cm³.

Regarding the transistor of figure 3 the region 10 has a doping concentration included between 10¹⁷ and 10¹⁸ atoms/cm³.

To note that all the process phases utilised for the formation of a bipolar transistor 1 are the same and are executed simultaneously to those for the formation on the same wafer of similar structures for the formation of a CMOS transistor in non volatile memories. Therefore, without modifying the building process and without adding further process phases.

Preferably the transistor 1 is a vertical transistor, which has better performances compared to a lateral transistor. In particularly, it has the distance between the emitter region 8 and the layer buried 4 (which corresponds to the thickness of region 3) lesser than the distance between the emitter region 8 and the isolating region 5. The transistor of figure 3 has the distance between the emitter region 10 and the buried layer 4 lesser than the distance between the emitter region 10 and the isolating region 5.

Since the gain of a vertical bipolar transistor is inversely proportional to the base doping, the vertical bipolar realised in a p-well at high voltage allows to obtain a higher gain compared to the same component realised in a p-well at low voltage.

To the aim of the present invention for low voltage is meant a voltage inferior to 5V and for high voltage a voltage superior to 5 V.

Referring now to the embodiment of figure 3, it is to note that the emitter active region 10 interfaces the field oxide 9 not with high doping doses as in figure 1, but with a doping typical dose of the transistor called "drain extension". In such a way the contact emitter area 8 (defined by the n+ high doping implanting of source and drain of the CMOS devices) doesn't interface directly the field oxide 9. The interface results of a better quality, if the doping dose of the area in contact with the field oxide 9 is the lowest possible.

In fact, this zone is notoriously a stressed region and it presents numerous imperfections that tend to decrease the gain in the bipolar devices. With the solution here proposed such inconveniences are eliminated and a higher gain of the transistor it is obtained.

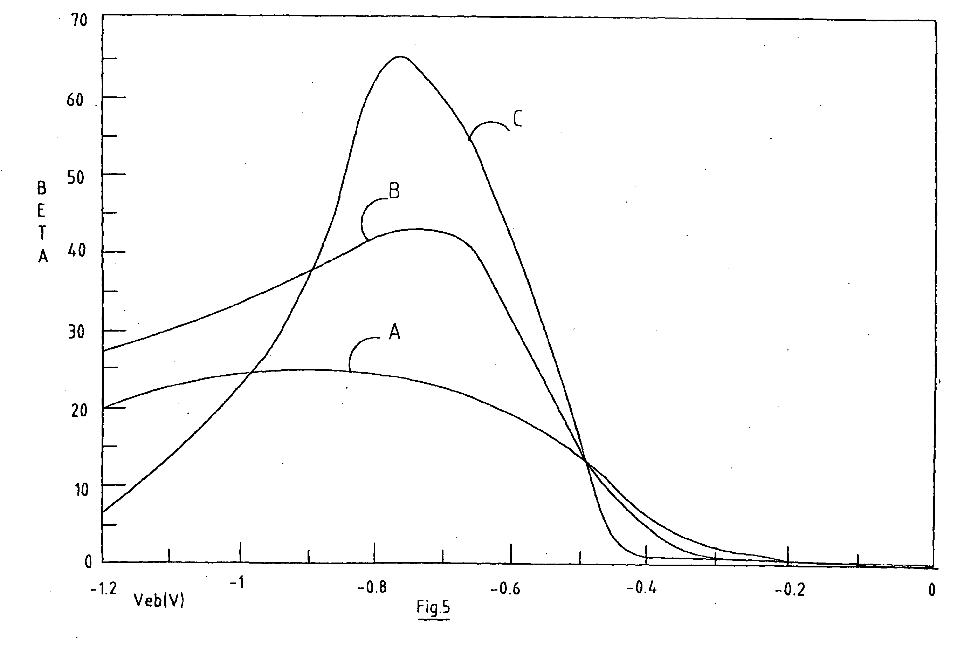

In figure 5 it is represented in a graph the trend of the gain current (Beta) of the transistor relate to the voltage between emitter and base (Veb).

The curve A, represents a transistor according to the known art using an ip-well semiconductor layer 3 of the type at low voltage.

The B curve, represents a transistor according to the first embodiment of the present invention in which the ip-well layer semiconductor 3 is of the type at high voltage.

The C curve, represents a transistor according to the second embodiment of the present invention in which the ip-well layer semiconductor 3 is of the type at high voltage and includes also the lightly doped layer 10.

To note as the gain (with Vbe included between 0.6 and 0.8 V) in the case of the curve A lightly overcomes the value of 20, in the case of the B curve has a gain over 40 and in the case of the C curve has a gain over 60 and preferably over than 65.

To note again that such results have been obtained using only the phases of process of a CMOS circuit for non volatile memories without the addition of new phases of process. The buried layer 4 is the same that is simultaneously formed on the same wafer to form an analogous isolating layer from the substrate of a nMOS transistor . The isolation layer 5 is the same that is formed simultaneously to form the n-well area of the pMOS devices. The contact base region 6 is formed simultaneously to the source and drain regions of a transistor pMOS. The emitter regions 8 and of contact collector 7 are formed simultaneously to the source and drain regions of a transistor nMOS.

## Claims

1. Building process for a bipolar transistor (1) obtained by means of a claims 1. CMOS devices process for non volatile memories having a gate regions, a source region and a drain region, comprising the phases of:
- forming a semiconductor buried layer (4) having a second type of conductivity on a substrate (2) having a first type of conductivity, simultaneously to the formation of a similar layer of buried semiconductor for said CMOS devices of n type,
- forming an isolation semiconductor layer (5) having a second type of conductivity in direct contact with said semiconductor buried layer (4) and adapted to contain a portion of said substrate (2) forming the base region (3) simultaneously to the formation of the n-well area of one of said CMOS devices of p type,
- forming an emitter region (8) and a collector contact region (7) respectively in said base region (3) and in said isolation semiconductor layer (5) having a second type of conductivity simultaneously to the formation a similar semiconductor layer for said source and drain regions of a said CMOS device of n type,
- forming a base contact region (6) of said transistor (1) in said base region (3) having a first type of conductivity simultaneously to the formation of a similar layer of semiconductor for said source and drain regions of said CMOS devices of p type.

2. Building process according to claim 1 **characterised in that** said process for CMOS devices is of the high voltage type.

## Patentansprüche

1. Herstellungsverfahren für einen mittels eines CMOS-Vorrichtungsverfahrens für nicht-flüchtige Speicher erhaltenen Bipolar-Transistor (1) mit einem Gate-Bereich, einem Source-Bereich und einem Drain-Bereich, aufweisend die Schritte:
- Bilden einer vergrabenen Halbleiter-Schicht (4) mit einem zweiten Typ an Leitfähigkeit auf einem Substrat (2) mit einem ersten Typ an Leitfähigkeit, gleichzeitig zum Bilden einer ähnlichen Schicht vergrabenen Halbleiters für die CMOS-Vorrichtungen des n-Typs;
- Bilden einer Halbleiter-Isolationsschicht (5) mit einem zweiten Typ an Leitfähigkeit in direktem Kontakt mit der vergrabenen Halbleiterschicht (4) und eingerichtet, einen Teil des den Basis-Bereich (3) bildenden Substrats (2) zu enthalten, gleichzeitig zum Bilden des n-Wannen-Bereichs von einem der CMOS-Vorrichtungen des P-Typs;
- Bilden eines Emitter-Bereichs (8) in dem Basis-Bereich (3) beziehungsweise eines Kollektor-Kontakt-Bereichs (7) in der Halbleiter-Isolationsschicht (5) mit einem zweiten Typ an Leitfähigkeit gleichzeitig zum Bilden einer ähnlichen Halbleiterschicht für die Source- und Drain-Bereiche einer CMOS-Vorrichtung des n-Typs;
- Bilden eines Basis-Kontakt-Bereichs (6) des Transistors (1) in dem Basis-Bereich (3) mit einem ersten Typ an Leitfähigkeit gleichzeitig zum Bilden einer ähnlichen Halbleiterschicht für die Source- und Drain-Bereiche der CMOS-Vorrichtungen des p-Typs.

2. Herstellungsverfahren gemäß Anspruch 1, **dadurch gekennzeichnet, dass** das Verfahren für CMOS-Vorrichtungen vom Hochspannungs-Typ ist.

## Revendications

1. Procédé de fabrication d'un transistor bipolaire (1) obtenu au moyen d'un procédé pour des dispositifs CMOS pour des mémoires non volatiles, présentant une région de grille, une région de source et une région de drain, comprenant les phases consistant à :
- former une couche enterrée de semi-conducteur (4) qui présente un second type de conductivité sur un substrat (2) qui présente un premier type de conductivité, simultanément à la formation d'une couche similaire de semi-conducteur enterrée pour lesdits dispositifs CMOS de type n,
- former une couche de semi-conducteur isolante (5) qui présente un second type de conductivité en contact direct avec ladite couche enterrée de semi-conducteur (4) et apte à contenir une partie dudit substrat (2) qui forme la région de base (3) simultanément à la formation d'une zone de puis n de l'un desdits dispositifs CMOS de type p,
- former une région d'émetteur (8) et une région de contact de collecteur (7) respectivement dans ladite région de base (3) et dans ladite couche de semi-conducteur isolante (5) qui présente un second type de conductivité simultanément à la formation d'une couche de semi-conducteur similaire pour lesdites régions de source et de drain d'un desdits dispositifs CMOS de type n,
- former une région de contact de base (6) dudit transistor (1) dans ladite région de base (3) qui présente un premier type de conductivité simultanément à la formation d'une couche similaire de semi-conducteur pour lesdites régions de source et de drain desdits dispositifs CMOS de type p.

2. Procédé de fabrication selon la revendication 1, **caractérisé en ce que** ledit procédé pour les dispositifs CMOS est du type à haute tension.
